# EUROPÄISCHE PATENTSCHRIFT

(11) **EP 3 384 410 B1**
(45) Veröffentlichungstag und Bekanntmachung des Hinweises auf die Patenterteilung: **05.05.2021**
(21) Anmeldenummer: 16826699.7
(22) Anmeldetag: 01.12.2016
(51) Int. Cl.: G06F 30/20, G06F 30/00

(54) **VERFAHREN ZUR DARSTELLUNG EINER SIMULATIONSUMGEBUNG**
METHOD FOR THE DISPLAY OF A SIMULATED SCENE
PROCÉDÉ DE VISUALISATION D'UNE SCÈNE SIMMULÉE

(30) Priorität: 02.12.2015 DE 102015120930
(43) Veröffentlichungstag der Anmeldung: 10.10.2018
(73) Patentinhaber: Krauss-Maffei Wegmann GmbH & Co. KG, 80997 München (DE)
(72) Erfinder: HAUBNER, Michael, 80997 München (DE); PABST, Manuel, 80097 München (DE)
(74) Vertreter: Feder Walter Ebert
(86) Internationale Anmeldenummer: PCT/DE2016/100564
(87) Internationale Veröffentlichungsnummer: WO 2017/092735

(56) Entgegenhaltungen:
- CA-C- 2 617 373
- US-B1- 7 102 646
- Anonymous: "Texture filtering - Wikipedia", , 4. August 2015 (2015-08-04), XP055359016, Gefunden im Internet: URL:https://en.wikipedia.org/w/index.php?t itle=Texture_filtering&oldid=684029019 [gefunden am 2017-03-27]

## Beschreibung

Die vorliegende Erfindung betrifft ein Verfahren, und zwar Darstellung einer computergenerierten, eine Realumgebung simulierenden Simulationsumgebung mit einer Datenbasis, welche die Daten eines realen Geländes und von in dem Gelände befindlichen realen Objekten beinhaltet.

Solche Verfahren zur Darstellung von Simulationsumgebungen kommen in unterschiedlichen Ausführungen zum Einsatz. Besonders, jedoch keinesfalls ausschließlich, werden derartige Verfahren zu Schulungs- und/oder Trainingszwecken verwendet. Der jeweilige Schulungs- und/oder Trainingszweck kann dabei höchst unterschiedlich sein. Demnach finden gattungsgemäße Verfahren beispielsweise Einsatz bei der Ausbildung und Schulung von Piloten und/oder Zugführern,
wie beispielsweise in CA2617373 A1 offenbart.

Allgemeiner ausgedrückt kommen derartige Verfahren zur Darstellung einer Simulationsumgebung bevorzugt dann zum Einsatz, wenn die im Rahmen der Simulation durchzuführende Tätigkeit, also die Interaktion eines Empfängers der Darstellung der Simulationsumgebung mit der Simulationsumgebung, in der Realität zu erheblichen Risiken gesundheitlicher und/oder finanzieller Natur führen würde.

Dementsprechend sind verwandte Verfahren zur Darstellung einer Simulationsumgebung auch aus dem militärischen Bereich bekannt, wobei sie gleichermaßen sowohl zu Ausbildungs- und Trainingszwecken von Fahrzeugführern und/oder Flugzugführern als auch zur Einsatzvorbereitung von Bodentruppen Verwendung finden.

In einer Vielzahl der vorangegangenen beschriebenen Einsatzzwecken von Verfahren zur Darstellung einer Simulationsumgebung sind die mit der Darstellung erreichten oder erreichbaren Schulungs- und/oder Trainingseffekte weitestgehend von einer realitätsgetreuen Abbildung der wirklichen Welt, also der Realumgebung, im Rahmen der Darstellung der Simulationsumgebung abhängig. Dies bedeutet für die Anwendung zur Einsatzvorbereitung im militärischen Bereich beispielsweise, dass eine Vorbereitung auf einen Einsatz umso effektiver stattfinden kann, desto mehr die Darstellung der Simulationsumgebung einer Realumgebung eines geplanten Einsatzes ähnelt.

Darüber hinaus hängt die Benutzbarkeit von Verfahren zur Darstellung einer computergenerierten, eine Realumgebung simulierenden Simulationsumgebung in besonderem Maße auch von der Echtzeit-Darstellung der Simulationsumgebung ab. Die Echtzeit-Darstellung betrifft allgemein jede Form der Interaktion des Benutzers mit der Simulationsumgebung, die einen Effekt oder eine Auswirkung auf die Darstellung der Simulationsumgebung hat.

Denn um eine realitätsnahe und effektive Simulation der Realumgebung mittels einer Darstellung einer computergenerierten Simulationsumgebung zu ermöglichen, es ist erforderlich, dass Benutzerinteraktionen, die einen Einfluss auf die Darstellung der Simulationsumgebung haben, wie beispielsweise eine Veränderung der Darstellungsposition oder der Darstellungsrichtung in der Simulationsumgebung, möglichst ohne jeglichen Zeitversatz, also unmittelbar oder in Echtzeit ausgeführt oder umgesetzt und dargestellt werden. Nur so entsteht für den Benutzer eine realistisch anmutende optische Sinneserfahrung im Rahmen der Darstellung der Simulationsumgebung.

Um jedoch eine hochgradige Übereinstimmung zwischen einer Realumgebung und einer die Realumgebung simulierenden Simulationsumgebung und deren Darstellung zu erreichen sowie gleichzeitig in der Lage zu sein, die Darstellung einer ebensolchen hochgradig realistisch anmutenden Simulationsumgebung innerhalb kürzester Zeit zu ändern oder anzupassen, sind unterschiedliche Schwierigkeiten zu überwinden.

Einerseits müssen Daten gewonnen werden, die die Realumgebung möglichst genau und detailgetreu abbilden. Die Gewinnung solcher Daten ist aufgrund von Satellitentechnik, wie beispielsweise GEO-Imaging sowie aufgrund unbemannter Aufklärungsfahrzeuge oder Aufklärungsflugzeuge, insgesamt weniger problematisch.

Größere Probleme stellen die durch die Abbildung der Realumgebung generierten Datenmengen sowie deren sinnvolle und effiziente Verwendung bei der Darstellung der die Realumgebung simulierenden Simulations-umgebung dar. Insbesondere stellen die Darstellungsrecheneinheiten, die als Teil von Grafikkarten oder anderer Hardware zur Darstellung einer computergenerierten, eine Realumgebung simulierenden Simulationsumgebung zum Einsatz kommen, wie beispielsweise in US7102646 B1 gezeigt, und aus den Daten der Datenbasis letztendlich ein Datensignal für eine grafische Darstellung auf einem wie auch immer gearteten Anzeigeelement generieren sowie der den Darstellungsrecheneinheiten zu diesem Zweck zugeordnete Darstellungsspeicher trotz ihrer jeweils stetig wachsenden Leistungsfähigkeit, einen Flaschenhals bei den Verfahren zur Darstellung einer Simulationsumgebung dar.

So ist es beispielsweise in der militärischen Einsatzvorbereitung einerseits von besonderem Interesse, dass sich die Benutzer in einer hochgradig mit der Realumgebung übereinstimmenden Simulationsumgebung aufhalten und in dieser bewegen können, was die detailreiche Darstellung der Simulationsumgebung für den Benutzer erfordert. Gleichzeitig ist es jedoch gerade bei einer militärischen Nutzung eines Verfahren zur Darstellung von computergenerierten Simulationsumgebungen notwendig, dass die Darstellung der Simulationsumgebung kurzfristig, abrupt und stark verändert wird, um beispielsweise die hektischen und abrupten Vorgänge, Bewegungen der Benutzer und Abläufe in einem Feuergefecht oder einer ähnlichen Situation im Rahmen der Darstellung der Simulationsumgebung simulieren, darstellen und wahrnehmen zu können.

Die **Aufgabe** der vorliegenden Erfindung liegt dementsprechend darin, ein Verfahren zur Darstellung einer computergenerierten, eine Realumgebung simulierenden Simulationsumgebung mit einer Datenbasis, in der Daten des realen Geländes und vom realen Gelände befindlichen realen Objekten mit beinhaltet sind, anzugeben, welches eine realitätsgetreue und schnelle, insbesondere reaktionsschnelle Darstellung der Simulationsumgebung ermöglicht.

Diese Aufgabe wird bei einem Verfahren der eingangs genannten Art mit den beschreibenden Merkmalen nach Patentanspruch 1 gelöst.

Vorteilhafte Weiterbildungen des Verfahrens werden mit den Merkmalen der abhängigen Patentansprüche 2-12 beschrieben.

Durch das erfindungsgemäße Verfahren wird in besonders vorteilhafter Weise eine hochgradig effektive und schnelle Verwendung der Kapazität des Darstellungsspeichers erreicht. Dadurch kann einerseits eine hochgradig realitätsgetreue Darstellung der Simulationsumgebung erreicht werden und zugleich die Geschwindigkeit beim Auslesen des Darstellungsspeichers und dem darauf aufbauenden Erzeugen eines Datensignals zur Erzeugung einer Darstellung der Simulationsumgebung auf einem Anzeigeelement weiter verbessert werden.

Denn die verwendeten vordefinierten Speicherbereiche einerseits lassen sich von einer entsprechenden Darstellungsrecheneinheit bereits besonders effektiv und schnell auslesen. Die erfindungsgemäße Anpassung der in der Datenbasis vorgehaltenen Daten, die das reale Gelände und die im realen Gelände befindlichen realen Objekte abbilden, an die entsprechende Größe der vordefinierten Speicherbereiche, erlaubt anderenfalls eine Priorisierung oder Gewichtung der Daten der Datenbasis in Abhängigkeit deren Bedeutung für den Grad der Realitätstreue der Darstellung der Simulationsumgebung. Dies bedeutet, dass Daten der Datenbasis, welche nur einen geringen Einfluss auf die Realitätstreue der Darstellung der Simulationsumgebung haben im Rahmen der Anpassung stärker vereinfacht, komprimiert und anschließend in entsprechend kleinere Speicherbereiche übertragen werden als Daten der Datenbasis, die einen großen Einfluss auf die Realitätstreue der Darstellung der Simulationsumgebung haben.

Die Vordefinition oder Vorabdefinition der Speicherbereiche soll dabei auch eine tatsächliche zumindest während der Laufzeit des Verfahrens statische Zuordnung von Speichereinheiten des Darstellungsspeichers umfassen. Dies bedeutet, dass im Rahmen des erfindungsgemäßen Verfahrens bei der Übertragung von Daten in oder an den Darstellungsspeicher immer wieder ein und dieselben Speicherbereiche des Darstellungsspeichers zum Einsatz kommen. Gerade auch dadurch können eine beschleunigtes Auslesen des Darstellungsspeichers und damit eine realistische Darstellung eines Teils der Simulationsumgebung in Echtzeit erfolgen.

Es kann also vorgesehen sein, dass ein bestimmter Teil des Darstellungsspeichers, oder sogar der gesamte Darstellungsspeicher grundsätzlich oder zumindest zu Beginn des Verfahrens in entsprechend vordefinierte und statische Speicherbereiche unterteilt wird, die dann entsprechend bei Bedarf und nach erfolgter Anpassung der Daten befüllt werden. Dies führt auch dazu, dass die vordefinierten Speicherbereiche, wenn erforderlich, immer vollständig neu beschrieben oder befüllt werden.

In einer ersten vorteilhaften Ausgestaltung des Verfahrens ist dabei vorgesehen, dass in den Speicherbereichen Umgebungsspeicherbereiche definiert werden, die jeweils zur Darstellung einer Kachel der Simulationsumgebung mit einer festen Grundfläche dienen, wobei die Gesamtheit der Kacheln eine zusammenhängende Teilfläche der Simulationsumgebung in der Umgebung der frei wählbaren Darstellungsposition abbilden. Beispielsweise kann vorgesehen sein, dass eine Kachel zur Abbildung eines Teils der Simulationsumgebung dient, die in der Realumgebung einer Fläche von 200 m x 200 m entspricht. Mit einer Matrix von neun aneinander angrenzenden Kacheln in einer 3x3-Anordnung könnte damit ein Teil der Simulationsumgebung abgebildet oder dargestellt werden, der eine Fläche von 600 m x 600 m der Realumgebung entspricht. In diesem Beispiel wären dementsprechend in den vordefinierten Speicherbereichen neun Umgebungsspeicherbereiche definiert.

Weiter kann vorgesehen sein, dass die Kacheln ein Teil der Simulationsumgebung darstellen oder abbilden, der sich in der Umgebung der frei wählbaren Darstellungsposition der Simulationsumgebung befindet. Im vorliegenden Beispiel mit einer Matrix aus 3x3-Kacheln, die zusammen-genommen eine zusammenhängende Teilfläche der Simulationsumgebung abbilden, kann vorgesehen sein, dass die Darstellungsposition so gewählt wird, dass sich die Darstellungsposition zu jedem Zeitpunkt in der zweiten Kachel der zweiten Reihe der Matrixanordnung der Kacheln befindet. Im vorliegenden Verfahren ist es umgekehrt jedoch besonders vorteilhaft, wenn zunächst die Darstellungsposition in der Simulationsumgebung bestimmt und in Abhängigkeit davon die Kacheln oder die Kachelanordnung um die Darstellungsposition herum festgelegt wird. Dies bedeutet jedoch auch, dass vorgesehen sein kann, dass sich eine bestimmte Kachelanordnung zusammen mit einer Veränderung der Darstellungsposition oder viel mehr aufgrund einer Veränderung der Darstellungsposition in der Simulationsumgebung, insbesondere schrittweise, verschiebt und die Gesamtheit der Kacheln den in jedem Moment der Darstellung der computergenerierten Simulationsumgebung dargestellten Ausschnitt der Simulationsumgebung definiert.

In einer vorteilhaften Ausführungsform des Verfahrens erfolgt eine einmalige Zuordnung eines Umgebungsspeicherbereichs zu einer Kachel der Simulationsumgebung, bezogen auf die frei wählbare Darstellungsposition und/oder die frei wählbare Darstellungsrichtung. Die einmalige Zuordnung kann besonders bevorzugt bei der Initiierung des Verfahrens zur Darstellung einer computergenerierten, eine Realumgebung simulierenden Simulationsumgebung erfolgen. In diesem Fall wird initial und endgültig festgelegt, welche Kachel, bezogen auf die frei wählbare und damit veränderbare Darstellungsposition und/oder Darstellungsrichtung in der Simulationsumgebung, welchem Umgebungsspeicherbereich der vordefinierten Speicherbereiche zugeordnet wird. Damit wird gleichzeitig auch festgelegt, welche Größe oder Datenmenge der jeweiligen Kachel der Simulationsumgebung, bezogen auf die Darstellungsposition und/oder Darstellungsrichtung zugewiesen wird, wodurch wiederum auch mitbestimmt wird, welche Eigenschaften und in welchem Ausmaß diese Eigenschaften der Daten der Datenbasis vor der Übertragung an den Darstellungsspeicher angepasst werden.

Eine solche einmalige Zuordnung zwischen den Umgebungsspeicherbereichen und den jeweiligen Kacheln hat den Vorteil, dass das Verfahren insgesamt vorhersehbarer wird und dadurch einfacher ausgeführt werden kann. Dies bedeutet, dass insgesamt die Rechenleistung der Darstellungsrecheneinheit eingespart oder anderweitig verwendet werden kann.

Gemäß einer alternativen Ausgestaltung kann jedoch ebenfalls vorgesehen sein, dass eine dynamische Zuordnung eines Umgebungsspeicherbereichs zu einer Kachel der Simulationsumgebung, bezogen auf die frei wählbare Darstellungsposition und/oder die frei wählbare Darstellungsrichtung, erfolgt.

Diese dynamische Zuordnung zwischen den Kacheln, die jeweils einen, bezogen auf die Darstellungsposition, festen Teil der Simulationsumgebung abbilden oder darstellen, und den unterschiedlich großen vordefinierten Umgebungsspeicherbereichen ermöglicht eine Anpassung an die jeweiligen Erfordernisse der aktuellen Darstellung der Simulationsumgebung.

Beispielsweise ermöglicht eine derartige dynamische Zuordnung zwischen den vordefinierten Umgebungsspeicherbereichen und den Kacheln der Simulationsumgebung, dass Kacheln, die sich in entgegengesetzter Richtung der Darstellungsrichtung und/oder in entgegengesetzter Richtung der Richtungsänderung der Darstellungsposition befinden, dynamisch jeweils anderen Umgebungsspeicherbereichen zugeordnet werden und dementsprechend die Anpassung der Daten der Datenbasis vor der Übertragung an die vordefinierten Speicherbereiche der Umgebungsspeicherbereiche entsprechend dynamisch ausfällt.

Dies ist vorteilhaft, da die genannten Kacheln wenig bis keinen Einfluss auf die Realitätstreue der Darstellung der Simulationsumgebung ausüben, da sie für den Benutzer in der jeweiligen Situation der Darstellung der Simulationsumgebung nicht oder nur am Rande des Sichtfelds wahrgenommen werden. Dementsprechend kann es vorteilhaft sein, die oben identifizierten Kacheln dynamisch mit vergleichsweise kleinen Umgebungsspeicherbereichen zu verknüpfen und die Daten der Datenbasis vor der Übertragung entsprechend stark zu vereinfachen oder zu komprimieren.

Dabei sei nochmals erwähnt, dass sich bei dem vorgeschlagenen Verfahren die Relativanordnung der Kacheln untereinander auch bei einer Veränderung der Darstellungsposition und/oder der Darstellungsrichtung nicht verändert. Das bedeutet, dass eine Kachel, die in einer ersten Situation noch in Richtung der Änderung der Darstellungsposition und/oder in Richtung der Darstellungsrichtung liegt, in einer darauffolgenden Situation nach einer Änderung der Darstellungsrichtung und/oder der Darstellungsposition sich seitlich zur aktuellen Darstellungsrichtung oder sogar entgegen der aktuellen Darstellungsrichtung befinden kann.

Um einer derartigen Veränderung durch das vorgeschlagene Verfahren entsprechend Rechnung tragen zu können, kann eine dynamische Zuordnung zwischen den Umgebungsspeicherbereichen und den Kacheln der Simulationsumgebung, bezogen auf die frei wählbare Darstellungsposition und/oder Darstellungsrichtung, besonders vorteilhaft sein, auch wenn die dynamische Zuordnung eine höhere Belastung der Darstellungsrecheneinheit darstellt.

In einer weiteren vorteilhaften Ausführungsform ist dementsprechend vorgesehen, dass die dynamische Zuordnung der Umgebungsspeicherbereiche zu den Kacheln der Simulationsumgebung, bezogen auf die frei wählbare Darstellungsposition in Abhängigkeit von der Änderung der Darstellungsposition und/oder der Darstellungsrichtung, erfolgt.

Darüber hinaus kann vorteilhaft vorgesehen sein, dass Kacheln der Simulationsumgebung in der Nähe der frei wählbaren Darstellungsposition größeren Umgebungsspeicherbereichen zugeordnet werden als Kacheln der Simulationsumgebung, die weiter von der frei wählbaren Darstellungsposition entfernt sind.

Im obigen Beispiel der Anordnung von 3x3-Kacheln, wobei sich die Darstellungsposition stetig in der zweiten Kachel der zweiten Reihe befindet, könnte diese Ausgestaltung derart umgesetzt sein, dass die zweite Kachel der zweiten Reihe, in der sich die Darstellungsposition befindet, einem entsprechend größeren Umgebungsspeicherbereich zugeordnet ist als die ringsum um diese Kachel angeordneten verbleibenden acht Kacheln. Besagte acht Kacheln können dementsprechend einem kleinen Umgebungsspeicherbereich der vordefinierten Speicherbereiche zugeordnet sein.

Dadurch wird ermöglicht, dass die Darstellung der Simulationsumgebung insgesamt an eine natürliche menschliche Wahrnehmung der Realumgebung angepasst wird. Denn durch das abstandsabhängige räumliche Auflösungsvermögen der menschlichen Augen können insgesamt in der unmittelbaren Umgebung mehr Details wahrgenommen werden als in größerer Entfernung. Dementsprechend wird eine realitätsnahe Darstellung einer computergenerierten, eine Realumgebung Simulationsumgebung auch dadurch weiter verbessert, dass in der näheren oder unmittelbaren Umgebung der Darstellungsposition mehr und insgesamt kleinere oder feinere Details wahrnehmbar gemacht werden.

Dies wird über eine entsprechende Zuordnung von größeren Umgebungsspeicherbereichen zu Kacheln in der näheren Umgebung der Darstellungsposition und einer entsprechenden Zuordnung von kleineren Umgebungsspeicherbereichen zu Kacheln mit einer entsprechend größeren Entfernung zur Darstellungsposition der Simulationsumgebung ermöglicht oder vereinfacht.

Dies bedeutet auch, dass die Teile der Datenbasis, die zur Übertragung an den Darstellungsspeicher an die jeweilige Größe der vordefinierten Speicherbereiche angepasst werden, bei entsprechend großen Speicherbereichen oder Umgebungsspeicherbereichen weniger angepasst werden müssen als bei kleinen Speicherbereichen. Dadurch wird letztlich ermöglicht, dass ein größerer Detailreichtum bei der Darstellung der Simulationsumgebung in der unmittelbaren Nähe der Darstellungsposition erreicht wird, der mit zunehmenden Abstand von der Darstellungsposition, insbesondere stufenweise an den Grenzen unterschiedlicher Kacheln abnimmt.

Eine andere vorteilhafte Ausführungsform sieht vor, dass Kacheln der Simulationsumgebung in der Nähe der Darstellungsrichtung größere Umgebungsspeicherbereiche zugeordnet werden als Kacheln der Simulationsumgebung, die weiter von der Darstellungsrichtung entfernt sind.

Dies spiegelt ebenfalls eine Eigenschaft der menschlichen, optischen Wahrnehmung wider, wonach im Zentrum des Blickfeldes mehr Details wahrgenommen werden als am Rand des Blickfeldes. Ganz abgesehen davon werden außerhalb des Blickfeldes überhaupt keine Details wahrgenommen. Dementsprechend kann durch eine Zuordnung von großen Umgebungsspeicherbereichen zu Kacheln der Simulationsumgebung, die sich entlang der aktuellen Darstellungsrichtung der Simulationsumgebung oder in deren Nähe erstrecken, diese natürliche Eigenschaft der menschlichen Wahrnehmung widerspiegeln. Die entsprechende Zuordnung der Umgebungsspeicherbereiche der vordefinierten Speicherbereiche sollte in diesem Fall jedoch dynamisch erfolgen, um eine entsprechende Veränderung der Zuordnung der Kacheln zu den Umgebungsspeicherbereichen zu ermöglichen, wenn sich die Darstellungsrichtung der Simulationsumgebung ändert.

Wie auch bei der zunehmenden Verkleinerung der Umgebungsspeicherbereiche mit zunehmendem Abstand zur Darstellungsposition kann bei einer Zuordnung in Abhängigkeit vom Abstand von der Darstellungsrichtung die Anpassung oder Vorverarbeitung der Daten der Datenbasis vor der Übertragung an den Darstellungsspeicher entsprechend ursächlich beeinflusst werden. Dies bedeutet, dass für größere Umgebungsspeicherbereiche entlang oder in der Nähe der Darstellungsrichtung eine geringere Anpassung hinsichtlich der Daten der Datenbasis an die Größe der vordefinierten Speicherbereiche des Darstellungsspeichers erfolgt als bei Daten der Datenbasis, die den Teil der Simulationsumgebung abbilden oder darstellen, der sich in einer Kachel abseits der Darstellungsrichtung befindet und dementsprechend einem kleineren Umgebungsspeicherbereich zugeordnet ist.

Dementsprechend kann vorteilhaft vorgesehen sein, dass die Umgebungsspeicherbereiche als Pyramide mit wenigen Speicherbereichen mit großer Größe und einer zunehmenden Anzahl von Speicherbereichen mit jeweils abnehmender Größe vordefiniert werden. Dadurch kann besonders vorteilhaft ein abgestuftes Detaillevel bei der Darstellung der Simulationsumgebung erreicht werden, was einerseits eine hochgradig realitätsgetreue Darstellung der Simulationsumgebung ermöglicht und andererseits gleichzeitig den vorhandenen Darstellungsspeicher optimal ausnutzt sowie die Anpassung der Daten der Datenbasis an die jeweiligen vordefinierten Speicherbereiche vor der Übertragung vom Primärspeicher in den Darstellungsspeicher optimiert.

Dies bedeutet, dass besonders vorteilhaft die Umgebungsspeicherbereiche als Verteilung mit weniger Speicherbereichen mit einer großen Größe und vielen Speicherbereichen mit einer kleinen Größe vordefiniert werden.

Es kann weiter besonders vorteilhaft sein, wenn die Speicherbereiche Fernsichtspeicherbereiche umfassen, die als wenige Speicherbereiche mit großer Größe vordefiniert werden. Dies ermöglicht eine Darstellung der computergenerierten, eine Realumgebung simulierenden Simulationsumgebung in unterschiedlichen Betriebsarten. Bei der ersten Betriebsart kann es sich beispielsweise um einen normalen oder natürlichen Darstellungszustand oder Betrachtungszustand handeln, der die Darstellung der Simulationsumgebung so betreibt, dass sie nach Möglichkeit einer realen Betrachtung der Realumgebung durch den Betrachter, insbesondere ohne die Benutzung technische Hilfsmittel, besonders nahe kommt. In einer zweiten Betriebsart, beispielsweise einer Zoom- oder Fernsichtbetriebsart, könnte das vorgeschlagene Verfahren die Darstellung der Simulationsumgebung derart betreiben, dass die Darstellung der Wahrnehmung eines Benutzers unter Verwendung eines technischen Hilfsmittels, wie beispielsweise einem Fernglas, einer Zieloptik oder einer sonstigen technischen optischen Vergrößerungseinrichtung entspricht.

Um diese Zoom- oder Fernsichtbetriebsart im Rahmen des vorgeschlagenen Verfahrens zur Darstellung einer computergenerierten, eine Realumgebung simulierenden Simulationsumgebung aktivieren und ausführen zu können, können besonders vorteilhaft Fernsichtspeicherbereiche als Teil der vordefinierten Speicherbereiche vorgesehen werden, die eine große Speicherkapazität aufweisen. Damit können dann bei der Aktivierung der Fernsichtbetriebsart, beispielsweise auch Kacheln, die sich in einer größeren oder großen Entfernung zu der Darstellungsposition befinden, einem entsprechend großen Fernsichtspeicherbereich zugeordnet werden, so dass in der Fernsichtbetriebsart auch in diesen Kacheln befindliche, weiter von der Darstellungsposition entferntere Teile der Simulationsumgebung mit einem hohen Detaillevel dargestellt werden können, so wie sie ein Benutzer bei der Betrachtung der Realumgebung mit einem entsprechenden technischen Hilfsmittel ebenfalls wahrnehmen würde.

In einer ebenfalls besonders bevorzugten Ausführungsvariante des vorgeschlagenen Verfahrens ist vorgesehen, dass die Umgebungsspeicherbereiche oder noch allgemeiner die vordefinierten Speicherbereiche als jeweils doppelter Satz vordefiniert werden. Dies hat zwar einerseits den Nachteil, dass die Größe der jeweiligen Speicherbereiche verringert, insbesondere halbiert wird, gleichzeitig resultiert daraus jedoch der Vorteil, dass bei einem doppelten Satz von vordefinierten Speicherbereichen, insbesondere vordefinierten Umgebungsspeicherbereichen, jeweils ein vollständiger Satz zur Ausführung der aktuellen Darstellung der Simulationsumgebung von dem Darstellungsrechner verwendet werden kann, während der zweite zur Darstellung der Simulationsumgebung aktuell nicht verwendete Satz von vordefinierten Speicherbereichen, insbesondere Umgebungsspeicherbereichen, mit Daten, insbesondere angepassten Daten aus der Datenbasis des Primärspeichers, befüllt werden kann. Dies bedeutet, dass das Auslesen der vordefinierten Speicherbereiche des Darstellungsspeichers und das Laden oder Befüllen der vordefinierten Speicherbereiche des Darstellungsspeichers parallel ablaufen können.

In einer weiteren bevorzugten Abwandlung des Verfahrens kann vorgesehen sein, dass die Definition der Speicherbereiche so ausgeführt wird, dass die Gesamtgröße der vordefinierten Speicherbereiche der Gesamtgröße des Darstellungsspeichers entspricht. Damit wird auf vorteilhafte Weise der im Darstellungsspeicher zur Verfügung stehende Speicherplatz optimal ausgenutzt.

In einer ebenfalls vorteilhaften Ausgestaltung des Verfahrens kann vorgesehen sein, dass bei einer Veränderung der frei wählbaren Darstellungsposition und/oder der frei wählbaren Darstellungsrichtung der Darstellung der Simulationsumgebung über einen Grenzwert, eine Anpassung von an den Darstellungsspeicher zu übertragenden Daten der Datenbasis in zumindest einer Eigenschaft an die Größe der vordefinierten Speicherbereiche und eine Übertragung der angepassten Daten an den Darstellungsspeicher erfolgt, wobei insbesondere die Übertragung der angepassten Daten an den Darstellungsspeicher den Inhalt aller Umgebungsspeicherbereiche oder eines vollständigen Satzes von Umgebungsspeicherbereichen ersetzt oder überschreibt.

Als Grenze oder Grenzwert, der die neuerliche Anpassung von Daten der Datenbasis an die vordefinierten Speicherbereiche des Darstellungsspeichers und deren anschließende Übertragung an den Darstellungsspeicher auslöst, können beispielsweise die jeweiligen Kachelgrenzen verwendet werden.

Diese Ausgestaltung betrifft damit das Auslösen einer neuerlichen Anpassung von Daten der Datenbasis an die vordefinierten Speicherbereiche und eine anschließende Übertragung in die Speicherbereiche. Da die Anordnung der Kacheln mit Bezug auf die Darstellungsposition erfolgt, ist es daher besonders vorteilhaft, die Kacheln oder die damit verbundenen Umgebungsspeicherbereiche neu zu befüllen oder neu zu laden, wenn die Darstellungsposition eine Grenze einer Kachel überschreitet.

Dies bedeutet, dass, wenn sich die Darstellungsposition der Simulationsumgebung über eine Kachelgrenze hinweg bewegt, die den Kacheln zugrunde liegenden Inhalte, also die Inhalte der vordefinierten Umgebungsspeicherbereiche neu geladen werden. Für eine derartige Ausgestaltung des Verfahrens ist es dementsprechend nicht erforderlich, dass sich die Positionierung der Kacheln in der Simulationsumgebung und der Inhalt der Umgebungsspeicherberieche bei jeder Änderung der Darstellungsposition ändern oder mit bewegen, sondern solange statisch und unverändert bleiben, bis eben die Darstellungsposition eine Kachelgrenze überschreitet.

Damit können in besonders vorteilhafter Weise die Anzahl der notwendigen Anpassungen der Daten der Datenbasis und die anschließenden Übertragungen an die vordefinierten Speicherbereiche minimiert werden.

In einer weiteren bevorzugten Ausführungsform des Verfahrens ist vorgesehen, dass die an den Darstellungsspeicher zu übertragenden Daten der Datenbasis hinsichtlich einer maximalen räumlichen Auflösung an die Größe der Speicherbereiche des Darstellungsspeichers angepasst werden. Beispielsweise kann vorgesehen sein, dass die Rasterdaten der Datenbasis in einer räumlichen Auflösung von ca. 5 cm vorliegen. Im Rahmen der Anpassung der Daten der Datenbasis an die Größe der vordefinierten Speicherbereiche des Darstellungsspeichers kann dementsprechend vorgesehen sein, dass für einzelne, mit entsprechend kleinen Umgebungsspeicherbereichen verknüpfte Kacheln der Simulationsumgebung die räumliche Auflösung der Rasterdaten auf beispielsweise 20 cm bis 40 cm herabgesetzt wird.

Damit kann je nach Zuordnung der Speicherbereiche zu den jeweiligen Kacheln in der Umgebung der Darstellungsposition der Simulationsumgebung eine besonders realitätsgetreue und natürliche Darstellung der Simulationsumgebung erreicht werden, bei der, wie auch bei der Wahrnehmung der Realumgebung, eine entsprechende variable räumlichen Auflösung gegeben bzw. natürlich ist.

Durch die Anpassung der Daten der Datenbasis hinsichtlich der räumlichen Auflösung vor der Übertragung an die entsprechend vorgesehenen Speicherbereiche des Darstellungsspeichers kann somit die Datenmenge zur Abbildung oder Darstellung einer Kachel der Simulationsumgebung entsprechend reduziert und diese Daten in einem entsprechend kleinen Speicherbereich des Darstellungsspeichers übertragen werden.

In einer weiteren besonders vorteilhaften Ausgestaltung sieht das vorgeschlagene Verfahren vor, dass die an den Darstellungsspeicher zu übertragenden Daten der Datenbasis hinsichtlich zur Darstellung der Rasterdaten, insbesondere zur Texturierung der Rasterdaten verwendeten Texturen an die Größe der Speicherbereiche des Darstellungsspeichers angepasst werden.

Als Beispiel für die Anpassung einer Textur kann zum Beispiel die Anpassung einer Farbtextur zur Darstellung eines realabbildenden Geländes der Simulationsumgebung herangezogen werden. Soll zum Beispiel Gras oder Wiese dargestellt werden, so kann die dafür vorgesehene Farbtexturierung einerseits sehr detailliert ausfallen, so dass Details bis hin zu einzelnen Grashalmen oder Grasbüscheln erkennbar sind. Andererseits kann die Texturierung jedoch auch bis hin zu einer mehr oder weniger einheitlichen einzelnen grünen Farbe reduziert werden.

Sollen also die in der Datenbasis gespeicherten Daten der Simulationsumgebung hinsichtlich einer zur Darstellung der Rasterdaten verwendeten Textur, insbesondere einer Farbtextur, an die Größe der mit der jeweiligen Kachel verknüpften Speicherbereich angepasst werden, so kann beispielsweise vorgesehen sein, dass bei einer Kachel, der ein verhältnismäßig kleiner Speicherbereich zugewiesen ist, eine vereinfachte oder reduzierte Textur aus den Daten der Datenbasis erzeugt oder soweit schon vorliegend entnommen wird und die so angepassten Daten vom Primärspeicher an den Darstellungsspeicher übertragen werden.

Ebenfalls vorteilhaft vorgesehen sein kann eine Ausführungsform, gemäß der die an den Darstellungsspeicher zu übertragenden Daten der Datenbasis hinsichtlich einer Minimalglättungstextur an die Größe der Speicherbereiche angepasst werden. Der Minimal-Glättungstextur kommt eine besondere Aufgabe hinsichtlich der Erzeugung der endgültigen Datensignale zur Darstellung der Simulationsumgebung seitens der Darstellungsrecheneinheit zu.

Denn die bekannten Darstellungsrecheneinheiten berechnen, ausgehend von den vorliegenden Rasterdaten Flächen, beispielsweise Dreiecksflächen. Dabei kann es Teil der Berechnung sein, dass die räumliche Auflösung der Rasterdaten im Bereich gleichmäßiger Oberflächen der Rasterdaten lokal verringert wird, um die Rechenlast der Darstellungsrecheneinheit zu verringern. Derartige Mechanismen werden im Fachjargon u. a. als "Tessellation Shader" bezeichnet. Dieses Vorgehen kann jedoch zu dem Problem führen, dass größere Erhebungen abhängig von deren Abstand zur Darstellungsposition nicht konstant dargestellt werden. Dies bedeutet, dass zum Beispiel Berge nicht immer gleich hoch dargestellt werden, je nachdem wie weit die Darstellungsposition von dem Berg oder dem Berggipfel entfernt ist. Die führt zu einer unnatürlichen Wahrnehmung der mit dem Verfahren dargestellten Simulationsumgebung.

Um dies zu vermeiden, kann eine entsprechende Minimal-Glättungstextur vorgesehen und gemäß der vorangegangen beschriebenen Ausführungsform an die Größe der Speicherbereiche angepasst werden, die jeweils ein minimal darzustellendes Höhenprofil festlegt. Auch diese Minimal-Glättungstextur kann als Teil der Anpassung der Daten der Datenbasis im Vorfeld der

Übertragung an den Darstellungsspeicher an die Größe der Speicherbereiche angepasst werden.

Ein ähnliches Phänomen tritt auf, wenn bei der Berechnung des endgültigen Datensignals durch die Darstellungsrecheneinheit im Rahmen der Verringerung der Auflösung der Rasterdaten unter Vergrößerung der Flächen, insbesondere Dreiecksflächen, Objekt- oder Geländeeigenschaften der Rasterdaten der Simulationsumgebung verloren gehen, die jedoch gerade im Nahbereich, also im näheren Umfeld der Simulationsumgebung um die Darstellungsposition einen wichtigen Aspekt hinsichtlich der Realitätstreue der Simulationsumgebung und deren Darstellung beinhalten.

Dementsprechend kann gemäß einer weiteren, besonders vorteilhaften Ausführung des vorgeschlagenen Verfahrens vorgesehen sein, dass die an den Darstellungsspeicher zu übertragenden Daten der Datenbasis hinsichtlich einer Maximal-Glättungstextur an die Größe der Speicherbereiche des Darstellungsspeichers angepasst werden. Diese Maximal-Glättungstextur enthält beispielsweise für jeden Höhenwert der Rasterdaten der Datenbasis in jeder der möglichen räumlichen Auflösungen einen Fehlerwert, der ein Maß dafür angibt, wie groß der Höhenfehler wäre, wenn die nächst schlechtere oder die nächst gröbere Auflösung verwendet würde. Unter Anwendung einer entsprechenden Fehlerwertschranke kann dann bei der Erzeugung des Datensignals durch die Darstellungsrecheneinheit entschieden werden, ob in einem bestimmten Bereich eine Verringerung der räumlichen Auflösung ohne einen Verlust wesentlicher Merkmale erfolgen kann oder nicht.

Auch diese Maximal-Glättungstextur kann vorteilhafterweise bereits an die Größe der Speicherbereiche des Darstellungsspeichers angepasst werden.

Hier sei der Vollständigkeit halber noch darauf verwiesen, dass die Reduzierung der Auflösung im Rahmen der Erstellung des Datensignals durch den Darstellungsrechners, bei dem Rasterpunkte zu Dreiecksflächen zusammengefasst werden, nicht mit der möglicherweise stattfindenden Anpassung der räumlichen Auflösung der Daten der Datenbasis zur Angleichung an die Größe der im Darstellungsspeicher vordefinierten Speicherbereiche vor der Übertragung der Daten an den Darstellungsspeicher zu verwechseln ist. Vielmehr können beide Anpassungen nacheinander stattfinden, die oben letztgenannte im Rahmen des vorgeschlagenen Verfahrens und die weitere Anpassung im Rahmen der Erstellung des Datensignal durch den Darstellungsrechners, der wiederum auf die in die vordefinierten Speicherbereichen übertragenen, angepassten Daten zurückgreift.

In der Vergangenheit haben sich insbesondere für rechenintensive grafische Anwendungen von Computersystemen, Hauptrecheneinheiten mit einer Mehrzahl von Rechenkernen oder Prozessoren, sogenannte Multi-Core-Prozessoren. als vorteilhaft erwiesen. Dabei stellen die jeweiligen Prozessoren oder Rechenkerne an und für sich einzelne Recheneinheiten dar, die von einer übergeordneten Struktur kontrolliert und koordiniert werden.

Auch für das vorgeschlagene Verfahren ist es im Rahmen einer vorteilhaften Ausführungsform vorgesehen, dass an den Darstellungsspeicher zu übertragende Daten der Datenbasis von jeweils unterschiedlichen Recheneinheiten hinsichtlich mehrere entsprechend unterschiedliche Eigenschaften gleichzeitig an die Größe der Speicherbereiche angepasst werden. Beispielsweise kann vorgesehen sein, dass eine erste Recheneinheit die Anpassung hinsichtlich einer räumlichen Auflösung vornimmt. Eine weitere Recheneinheit kann beispielsweise die Anpassung einer Textur, wie beispielsweise einer Farbtextur, vornehmen. Darüber hinaus können weitere Recheneinheiten vorgesehen sein, die analog zu den vorgenannten Beispielen jeweils eine Eigenschaft der Daten der Datenbasis an die Größe der Speicherbereiche des Darstellungsspeichers angepasst und an den Darstellungsspeicher übertragen werden.

Eine solche parallele Bearbeitung oder Anpassung der Daten der Datenbasis kann die insgesamt benötigte Dauer zur Anpassung der Daten deutlich verringern.

In einer weiteren Ausführungsform des Verfahrens ist vorgesehen, dass die an den Darstellungsspeicher zu übertragenden Daten der Datenbasis hinsichtlich der Größe von Datenpaketen an die Größe der jeweiligen Speicherbereiche angepasst werden. Dieser Ausgestaltung liegt die Überlegung zugrunde, dass große Datenpakete schneller ausgelesen werden können als kleine Datenpakete. Besonders vorteilhaft kann deshalb vorgesehen sein, dass die an einen jeweiligen Speicherbereich des Darstellungsspeichers zu übertragenden Daten der Datenbasis im Rahmen der Anpassung zu je einem einzigen Datenpaket zusammengefasst werden, dessen Größe der Größe des vordefinierten Speicherbereichs entspricht.

In einer weiteren Ausführungsform des Verfahrens ist vorgesehen, dass nach Abschluss der Anpassung der zu übertragenden Daten an die Größe des jeweiligen Speicherbereichs der Abschluss der Anpassung in einer Abrufliste des Primärspeichers gespeichert wird. Dadurch wird vorteilhaft ermöglicht, die jeweils fertiggestellten Daten, also die jeweils vollständig an die Größe des entsprechenden Speicherbereichs angepassten Daten der Datenbasis, möglichst zeitnah oder möglichst zeit- und ressourcenoptimiert an den Darstellungsspeicher zu übertragen.

In einer weiteren vorteilhaften Variante des Verfahrens wird vorgeschlagen, dass in der Datenbasis eine Veränderungstextur definiert wird, die eine dauerhafte Veränderung der Simulationsumgebung abbildet. Eine derartige Veränderungstextur wird besonders bevorzugt als unabhängige Textur definiert, die zwar zusammen mit den verbleibenden Daten der Datenbasis eine Veränderung der Simulationsumgebung abbilden und auch abspeichern kann, die Veränderungen jedoch nicht dauerhaft oder unwiderruflich sind. Die Veränderungstextur oder die Veränderungstexturen sind besonders dann von Vorteil, wenn das Verfahren zur Darstellung der Simulationsumgebung auch in einer Veränderungsbetriebsart betrieben werden soll, in der beispielsweise Veränderungen des realabbildenden Geländes oder der realabbildenden Gebäude der Simulationsumgebung vorgenommen, dargestellt und zumindest für einen gewissen Zeitraum beibehalten werden sollen.

Eine solche Veränderungstextur kann, wie die anderen oben bereits beschriebenen Texturen, gleichermaßen einer Anpassung an die Größe der Speicherbereiche des Darstellungsspeichers vor der Übermittlung an den Darstellungsspeicher unterzogen werden.

Weitere Vorteile und Einzelheiten des erfindungsgemäßen Verfahrens werden nachfolgend unter Zuhilfenahme der beigefügten, schematisierten Zeichnungen von Ausführungsbeispielen erläutert werden. Darin zeigen:
- Fig. 1: ein schematisiertes Ablaufdiagramm des erfindungsgemäßen Verfahrens gemäß einer Ausführungsform;
- Fig. 2: eine schematisierte Darstellung einer Vorrichtung zur Ausführung des erfindungsgemäßen Verfahrens;
- Fig. 3a: eine beispielshafte Darstellung eines Teils einer Simulationsumgebung sowie einer Anordnung von Kacheln in der Simulationsumgebung;
- Fig. 3b: eine beispielhafte Darstellung eines Teils einer Simulationsumgebung sowie einer veränderten Anordnung von Kacheln gegenüber Fig. 3a;
- Fig. 4: eine alternative Anordnung von Kacheln in der Simulationsumgebung zur Darstellung der Simulationsumgebung in einer Fernsichtbetriebsart;
- Fig. 5: eine alternative Anordnung von Kacheln zur Darstellung eines Teils der Simulationsumgebung mit dem erfindungsgemäßen Verfahren.

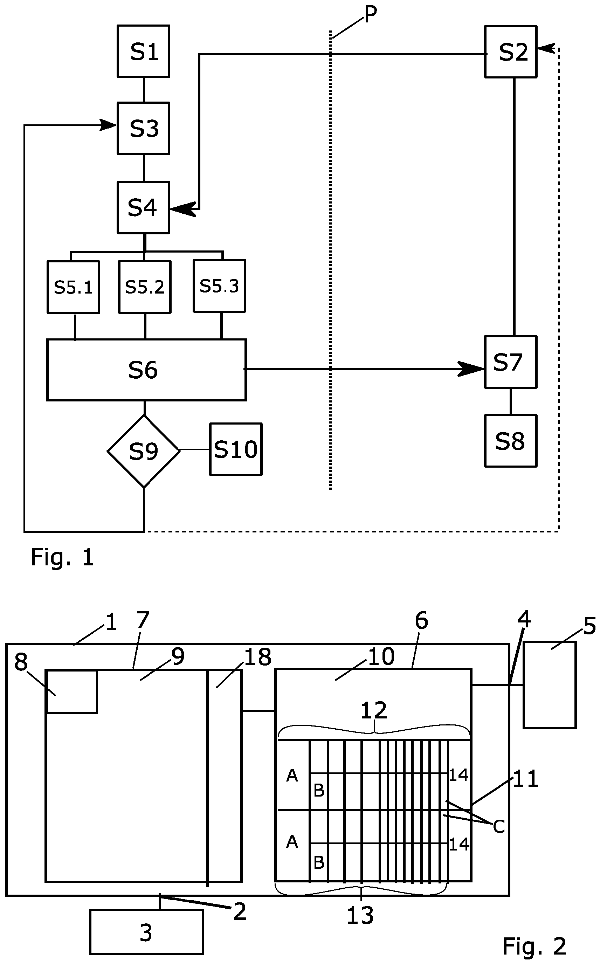

Die Fig. 1 zeigt ein schematisiertes Ablaufdiagramm, welches einen beispielhaften Ablauf einer Ausführungsform des erfindungsgemäßen Verfahrens veranschaulicht. Dabei ist das Ablaufdiagramm der Fig. 1 durch eine punktierte Linie P in eine linke Seite und eine rechte Seite unterteilt. Die linke Seite stellt Abläufe dar, die im Bereich einer Hauptrecheneinheit 8 eines allgemeinen Computersystems 1 in Verbindung mit einem Primärspeicher ausgeführt werden. Die rechte Seite der Fig. 1 zeigt Verfahrensschritte, die auf Seiten einer Darstellungseinheit, umfassend den Darstellungsspeicher und die Darstellungsrecheneinheit, ausgeführt werden.

In einem ersten Verfahrensschritt S1 wird die Darstellungsposition und ggf. die Darstellungsrichtung festgestellt, aus der oder aus denen die Darstellung der Simulationsumgebung erfolgen soll. In einem zweiten Verfahrensschritt S2 wird auf Seiten der Darstellungseinheit eine Anordnung von Kacheln zur Darstellung eines zusammenhängenden Teils der Simulationsumgebung festgelegt und den jeweiligen Kacheln ein Speicherbereich in dem Darstellungsspeicher zugewiesen. Gleichzeitig werden die entsprechenden Speicherbereiche im Darstellungsspeicher vordefiniert. Im Anschluss daran werden die Informationen über die definierte Kachelanordnung, die dazu gehörigen Speicherbereiche und die jeweiligen Größen der vordefinierten Speichbereiche von der Darstellungseinheit an die Hauptrecheneinheit übertragen.

Basierend auf den Informationen über die Kachelanordnung zur Darstellung eines Teils der Simulationsumgebung, der entsprechenden Zuordnung zu Speicherbereichen des Darstellungsspeichers und den jeweiligen Größen der Speicherbereiche werden im anschließenden Verfahrensschritt S3 unter Berücksichtigung der im Verfahrensschritt S1 festgestellten Darstellungsposition und ggf. Darstellungsrichtung zur Darstellung der Simulationsumgebung die Daten der Datenbasis identifiziert, die die von der Kachelanordnung unter Berücksichtigung der Darstellungsposition aufgespannte Teilfläche der Simulationsumgebung abbilden. Diese Identifizierung der Daten der Datenbasis im Primärspeicher erfolgt nicht nur für die Kachelanordnung insgesamt, sondern auch für jede einzelne Kachel.

Nach der Identifizierung der Daten der Datenbasis im Primärspeicher, die die Daten zur Darstellung der Simulationsumgebung der einzelnen Kacheln aufweisen, wird im Verfahrensschritt S4 die zu der jeweiligen Kachel gehörige Größe des im Darstellungsspeicher vordefinierten Speicherbereichs identifiziert. Daraus werden im Anschluss daran Anpassungsvorschriften generiert, die die Daten der Datenbasis der Simulationsumgebung für die jeweilige Kachel an die Größe des entsprechenden Speicherbereichs, wie sie im Darstellungsspeicher vordefiniert sind, anpassen.

In den anschließenden Verfahrensschritten S5.1 bis S5.3 und den darüber hinausgehenden, in der Fig. 1 jedoch aus Gründen der Darstellbarkeit nicht gezeigten, weiteren parallelen Verfahrensschritten werden die im Verfahrensschritt S4 abgeleiteten Anpassungsvorschriften auf die Daten der Datenbasis, wie sie im Primärspeicher vorliegen, angewendet. Das Resultat sind Datenstrukturen, die jeweils die mit einer Kachel verbundene Grundfläche der Simulationsumgebung abbilden oder darstellen und die hinsichtlich des Volumens oder der Größe der Datenmenge an die vordefinierten Speicherbereiche des Darstellungsspeichers angepasst sind, wobei die Gesamtheit der so aufbereiteten Daten der Datenbasis die zusammenhängende Teilfläche der Simulationsumgebung abbildet oder darstellt, die von der Gesamtheit der Kacheln umfasst wird. Dieses Ergebnis oder diese Daten werden im Verfahrensschritt S6 gesammelt. Der Abschluss der Anpassung der Daten für einen jeweiligen Speicherbereich wird dabei in einer Liste des Primärspeichers vermerkt. Anschließend werden die angepassten Daten vom Primärspeicher an den Darstellungsspeicher übertragen. Im Darstellungsspeicher werden im Verfahrensschritt S7 die eingehenden Daten gemäß ihrer Größe und Zuordnung zu den entsprechenden Kacheln in die vordefinierten Speicherbereiche geladen.

Im Verfahrensschritt S8 folgt daraufhin das Auslesen der in den vordefinierten Speicherbereichen befindlichen Daten und die endgültige Generierung eines Datensignals zur Darstellung der Simulationsumgebung an einem Anzeigeelement.

Im Verfahrensschritt S9 wird seitens der Hauptrecheneinheit 8 überprüft, ob und inwieweit sich die Darstellungsposition der Simulationsumgebung und die Darstellungsrichtung der Simulationsumgebung geändert haben. Ist dies nicht der Fall, so endet das Verfahren mit dem Verfahrensschritt S10. Sollte sich die Darstellungsposition jedoch über einen Grenzwert hinaus, insbesondere über eine Kachelgrenze hinaus verändert haben, so springt das in Fig. 1 dargestellte Verfahren einerseits zurück in den Verfahrensschritt S3 und beginnt dort von neuem.

Andererseits kann beispielsweise bei einer dynamischen Zuordnung zwischen der jeweiligen Kachel und dem entsprechenden Speicherbereich bei einer Feststellung einer entsprechenden Änderung der Darstellungsposition und/oder der Darstellungsrichtung im Verfahrensschritt S9 auch vorgesehen sein, dass das Verfahren auf Seiten der Darstellungseinheit in den Verfahrensschritt S2 zurückspringt und dort eine neue Zuordnung zwischen den Speicherbereichen und den Kacheln vorgenommen wird, die dann anschließend an die Hauptrecheneinheit 8 zurückgeliefert wird.

Fig. 2 zeigt schematisch ein Computersystem 1 zur Ausführung des erfindungsgemäßen Verfahrens. An das Computersystem 1 ist über eine Eingabeschnittstelle 2 eine Eingabeeinheit 3 und über eine Ausgabeschnittstelle 4 ein Anzeigeelement 5 angeschlossen. Das Computersystem 1 ist dabei intern zweigeteilt zwischen einer Darstellungseinheit 6 und einer allgemeinen Recheneinrichtung 7. Die allgemeine Recheneinrichtung 7 umfasst dabei einen oder mehrere Hauptrecheneinheiten 8 sowie den Primärspeicher 9. Darüber hinaus ist die allgemeine Recheneinrichtung 7 mit der Darstellungseinheit 6 verknüpft. Die Darstellungseinheit 6 umfasst wiederum eine Darstellungsrecheneinheit 10 sowie einen Darstellungsspeicher 11. Der Darstellungsspeicher 11 ist dabei in eine Vielzahl während der Laufzeit vordefinierte Speicherbereiche 12 unterteilt.

Auch wenn die Darstellung der Fig. 2 stark schematisiert ist, so ist doch zumindest im Hinblick auf die vordefinierten Speicherbereiche 12 die Unterteilung des Darstellungsspeicher 11 recht bildlich zu verstehen. Die Speicherbereiche 12 sind feste statische Teile des Darstellungsspeichers. Auch wenn diese, im Gegensatz zur Darstellung der Fig. 2 nicht zwangsläufig zusammenhängend oder in einer geordneten Abfolge oder Anordnung vordefiniert sein müssen, so bleibt doch festzuhalten, dass die Speicherbereiche unverrückbar und unveränderbar während der Laufzeit des Verfahrens sind. Dies bedeutet bildlich gesprochen, dass bei einer neuerlichen Übertragung von Daten in der Darstellungsspeicher 11 die die Speicherberieche 11 abgrenzenden Linien nicht verschoben werden würden. Die Speicherberieche 12 sind vordefiniert.

Gerade auch dadurch kann ein besonders effektives Auslesen des Darstellungsspeichers 11 erfolgen, da der jeweilige Speicherort anhand der vordefinierten Speicherbereiche vordefiniert und dementsprechend vorab bekannt ist.

Die Speicherbereiche 12 umfassen einerseits Umgebungsspeicherbereiche 13, wobei die Umgebungsspeicherbereiche 13 als eine Pyramide mit wenigen großen und jeweils zunehmenden kleineren Speicherbereichen vordefiniert sind. Die Umgebungsspeicherbereiche weisen die Größen A, B und C auf. Darüber hinaus weisen die vordefinierten Speicherbereiche 12 auch Fernsichtspeicherbereiche 14 auf. Im Beispiel der Fig. 2 liegen sowohl die Umgebungsspeicherbereiche 13 als auch die Fernsichtspeicherbereiche 14 als doppelter Satz vor, die es ermöglichen, einen ersten Satz der Speicherbereiche 13 und 14 zum Auslesen und einen zweiten Satz der Speicherbereiche 13 und 14 zum Schreiben zu verwenden.

Die Darstellungsrecheneinheit 10 ist dazu eingerichtet, die Daten aus den Speicherbereichen 13 und/oder 14 auszulesen und daraus ein Datensignal zu erzeugen, mit dem auf dem Anzeigeelement 5 die Darstellung der computergenerierten, eine Realumgebung simulierenden Simulationsumgebung erfolgt. Gleichermaßen ist die Eingabeeinrichtung 3 über die Eingabeschnittstelle 2 derart mit dem Computersystem 1 verbunden, dass ein Benutzer eine Veränderung der Darstellung der Simulationsumgebung oder sogar eine Interaktion mit der Darstellung der Simulationsumgebung verursachen kann. Insbesondere kann mittels der Eingabeeinrichtung 3 die Darstellungsposition und/oder die Darstellungsrichtung der Simulationsumgebung verändert werden.

In dem Primärspeicher 9 sind u. a. die Daten der Datenbasis hinterlegt, die das reale Gelände und die im realen Gelände befindlichen realen Objekte abbilden. Teil der Daten der Datenbasis sind die Rasterdaten zur Beschreibung der Topografie des Geländes und der Objekte in der Simulationsumgebung. Die Hauptrecheneinheit 8 oder die mehreren Hauptrecheneinheiten der allgemeinen Recheneinrichtung 7 kann/können auf die Daten der Datenbasis der Simulationsumgebung im Primärspeicher 9 zugreifen und diese bearbeiten. Dies erfolgt beispielsweise, wenn wie mit Bezug auf Fig. 1 beschrieben, die allgemeine Recheneinrichtung 7 von der Darstellungsrecheneinheit 6 die festgelegte Kachelanordnung sowie die dazugehörigen vordefinierten Speicherbereiche 13 und 14 mitsamt den Größen der Speicherbereiche 13 und 14 mitgeteilt bekommt und im Anschluss daran die im Primärspeicher gespeicherten Daten der Datenbasis nach Kacheln und entsprechenden Speicherbereichen gegliedert an die jeweilige Größe der vordefinierten Speicherbereiche anpasst.

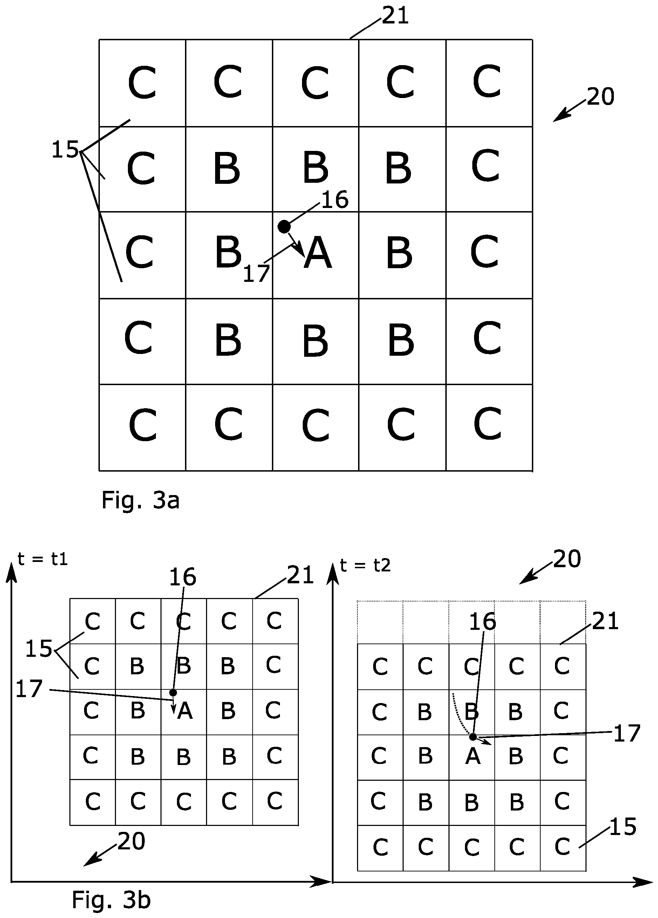

Fig. 3a zeigt ein erstes Beispiel einer Kachelanordnung 21, wobei jede Kachel 15 einen Teil der Simulationsumgebung 20 mit einer festen Grundfläche abbildet. Jeder der Kacheln 15 ist dabei ein Umgebungsspeicherbereich 13 des Darstellungsspeichers 11 zugeordnet. Die Größe des jeweiligen Umgebungsspeicherbereichs 13 der entsprechenden Kachel 15 wird durch die in der Fig. 3a dargestellten Buchstaben A, B und C veranschaulicht, wobei der Buchstabe A für einen großen vordefinierten Umgebungsspeicherbereich des Darstellungsspeichers steht, der Buchstabe B für einen entsprechend kleineren vordefinierten Umgebungsspeicherbereich und der Buchstabe C schließlich für einen noch kleineren vordefinierten Umgebungsspeicherbereich steht.

Dabei ist jedoch darauf hinzuweisen, dass die von den Kacheln 15 jeweils dargestellten Ausschnitte oder Teile der Simulationsumgebung 20 hinsichtlich ihrer Grundfläche konstant sind. Dies bedeutet, dass für eine Kachel mit einem Umgebungsspeicherbereich der Größe A ein gleich großer Teil der Simulationsumgebung dargestellt wird wie von einer Kachel mit einem Umgebungsspeicherbereich der Größe C.

In der Fig. 3a ist auch die Darstellungsposition 16 eingezeichnet, von denen aus die Darstellung der Simulationsumgebung 20 erfolgt. Aus der Fig. 3a kann so entnommen werden, dass der Kachel, in der sich die Darstellungsposition 16 befindet, der größte Umgebungsspeicherbereich mit der Größe A zugeordnet wird, und dass die von der Kachel mit dem größten Umgebungsspeicherbereich A umgebenden Kachel jeweils ein Umgebungsspeicherbereich mit der Größe B aufweisen. Lediglich die von der Darstellungsposition 16 am weitesten entfernten Kacheln 15 sind mit einem Umgebungsspeicherbereich der Größe C verknüpft.

Damit wird ermöglicht, dass die Darstellung der Simulationsumgebung 20, nämlich der von der Kachelanordnung 21 der Kacheln 15 erfasste Teil der Simulationsumgebung 20 optimal und realitätsnah dargestellt werden, da in der Nähe der Darstellungsposition 16 eine hohe detailtreue oder ein hohes Detaillevel realisiert werden kann, da der dafür vorgesehene Umgebungsspeicherbereich mit der Größe A ein entsprechendes Volumen zur Verfügung stellt. In einem zunehmenden Abstand von der Darstellungsposition 16 wird ein entsprechend geringeres Detaillevel erreicht, was durch die Umgebungsspeicherbereiche mit den Größen B und C bedingt wird. Dies entspricht jedoch ebenfalls der natürlichen menschlichen Wahrnehmung von weiter entfernter Umgebung.

Die Darstellung der Fig. 3b dient zur Veranschaulichung des Nachladens, also eines erneuten Anpassens von Daten der Datenbasis an die jeweilige Größe der vordefinierten Speicherbereiche, und anschließender Übertragung der so angepassten Daten an den Darstellungsspeicher infolge einer Veränderung der Darstellungsposition.

Im linken Teil der Fig. 3b befindet sich die Darstellungsposition 16 an einer ersten Position 19 zu einem Zeitpunkt t = t1 in der Simulationsumgebung 20. Dementsprechend sind mit dem erfindungsgemäßen Verfahren Daten aus der Datenbasis durch eine Anpassung generiert worden, die die von den jeweiligen Kacheln 15 erfassten Teile der Simulationsumgebung 20 abbilden und gleichzeitig an die Größe A, B und C der Umgebungsspeicherbereiche der jeweiligen Kacheln angepasst sind. Solange sich im Anschluss an die in der ersten Situation der Fig. 3b, nämlich der linken Situation zum Zeitpunkt t = t1 lediglich die Darstellungsrichtung 17, nicht jedoch die Darstellungsposition 16, ändert, kann die Darstellung der Simulationsumgebung anhand der im Darstellungsspeicher vorgehaltenen Daten für die Kacheln 15 erfolgen.

Verändert sich jedoch die Darstellungsposition 16 in der Folge der Situation zum Zeitpunkt t = t1 und überschreitet die Darstellungsposition 16 beispielsweise zu einem späteren Zeitpunkt t2, wie im rechten Teil der Fig. 3 dargestellt, eine Grenze, insbesondere eine Kachelgrenze, so wird dadurch eine neuerliche Anpassung von Daten der Datenbasis und eine anschließende Übertragung an den Darstellungsspeicher initiiert.

In der Darstellung des Zeitpunkts t = t2 der Fig. 3b erfolgt dabei keine Neuzuordnung zwischen den Umgebungsspeicherbereichen zu einer Kachel 15 in Abhängigkeit von der Darstellungsposition. Dies bedeutet, dass die Zuordnung der Umgebungsspeicherbereiche zu den Kacheln in Abhängigkeit der frei wählbaren Darstellungsposition 16 nicht dynamisch ist, sondern einmalig zu Beginn des Verfahrens festgelegt wird.

In der Darstellung des Zeitpunkts t = t2 der Fig. 3b hat sich also gegenüber dem Zeitpunkt t =t1 folgendes verändert: Es wird nunmehr anhand der Kacheln 15 ein veränderter bzw. ein verschobener Ausschnitt der Simulationsumgebung 20 abgebildet.

Umgekehrt hat sich zum Zeitpunkt t= t2 gegenüber dem Zeitpunkt t=t1 folgendes nicht verändert: Die Kachel 15, in der sich die Darstellungsposition 16 befindet, ist nach wie vor einem größtmöglichen vordefinierten Umgebungsspeicherbereich 12 mit der Größe A zugeordnet. Mit dem Abstand von der Darstellungsposition 16 nehmen die Größen A, B und C der den Kacheln 15 zugeordneten Umgebungsspeicherbereichen 12 ab. Folglich ermöglicht das beschriebenen Verfahren, das auch bei einer Änderung der Darstellungsposition 16 der Benutzer stets die vorteilhafte, realitätsnahe Darstellung der Simulationsumgebung wahrnehmen kann.

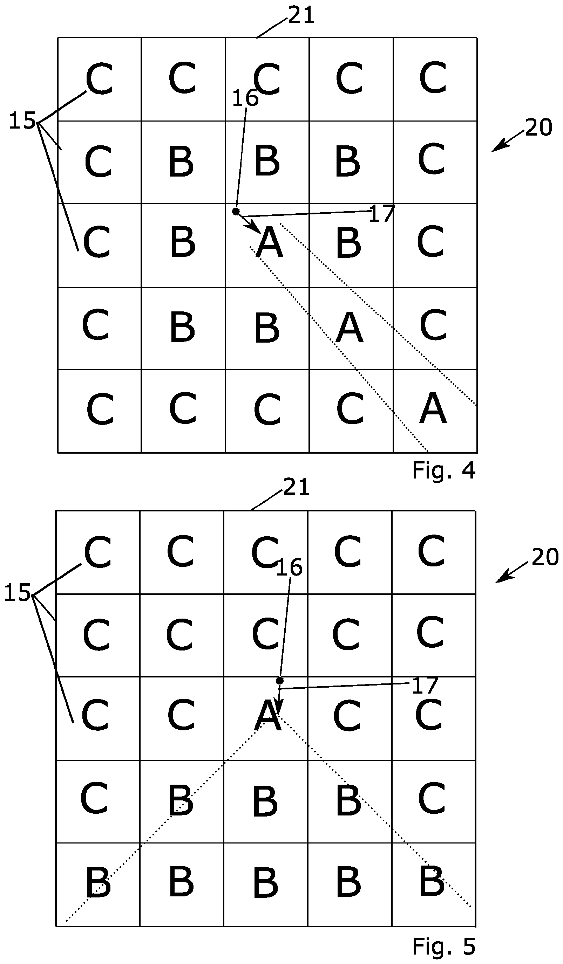

Die in der Fig. 4 dargestellte Kachelanordnung 21 zeigt die Darstellung der Simulationsumgebung in eine Fernsichtbetriebsart. Denn ausgehend von der Darstellungsposition 16 sind in Richtung der Darstellungsrichtung 17 auch weiter von der Darstellungsposition 16 entfernte Kacheln 15 einem großen Umgebungsspeicherbereich 13 mit der Größe A zugeordnet. Damit kann die Verwendung eines technischen, optischen Hilfsmittels oder einer Sichtunterstützung, wie beispielsweise die Verwendung eines Fernglases oder einer Zieloptik, im Rahmen der Darstellung der Simulationsumgebung veranschaulicht oder simuliert werden.

Die Fig. 5 zeigt eine alternative Kachelanordnung 21 von Kacheln 15, die ebenfalls ein zusammenhängendes Teilgebiet der Simulationsumgebung 20 abbilden, wobei jedoch die Zuordnung zwischen den Kacheln 15 und den Umgebungsspeicherbereichen 13 nicht nur von der Darstellungsposition 16, sondern auch von der Darstellungsposition 17 abhängt. Dementsprechend sind Kacheln 15 der Simulationsumgebung 20 in der Nähe der Darstellungsrichtung 17 größere Umgebungsspeicherbereiche 13, nämlich Umgebungsspeicherbereiche 13 mit einer Größe B zugeordnet als Kacheln 15 der Simulationsumgebung 20, die weiter von der Darstellungsrichtung 17 entfernt sind und lediglich einem Umgebungsspeicherbereich 13 mit einer Größe C zugeordnet sind.

Bei der in der Fig. 5 dargestellten Zuordnung zwischen den Kacheln 15 und den Umgebungsspeicherbereichen 13 kann die Zuordnung jedoch nicht, wie beispielsweise in der Fig. 3b beschrieben, statisch erfolgen. Vielmehr ist es zweckmäßig, auch bereits bei einer Veränderung der Darstellungsrichtung 17 die Zuordnung zwischen den Umgebungsspeicherbereichen 13 zu den Kacheln 15, bezogen auf die frei wählbare Darstellungsposition 16, dynamisch anzupassen. Eine derartige dynamische Anpassung macht jedoch auch ein häufigeres Anpassen und Übertragen der Daten der Datenbasis nötig.

### Bezugszeichen:

- 1: Computersystem
- 2: Eingabeschnittstelle
- 3: Eingabeeinheit
- 4: Ausgabeschnittstelle
- 5: Anzeigeelement
- 6: Darstellungseinheit
- 7: allgemeine Recheneinrichtung
- 8: Hauptrecheneinheit
- 9: Primärspeicher
- 10: Darstellungsrecheneinheit
- 11: Darstellungsspeicher
- 12: Speicherbereich
- 13: Umgebungsspeicherbereich
- 14: Fernsicht-Speicherbereich
- 15: Kachel
- 16: Darstellungsposition
- 17: Darstellungsrichtung
- 18: Abrufliste
- 20: Simulationsumgebung
- 21: Kachelanordnung
- t1: erster Zeitpunkt
- t2: zweiter Zeitpunkt
- P: punktierte Linie
- A: erste Größe eines Umgebungsspeicherbereichs
- B: zweite Größe eines Umgebungsspeicherbereichs
- C: dritte Größe eines Umgebungsspeicherbereichs

## Patentansprüche

1. Verfahren zur Darstellung einer computergenerierten, eine Realumgebung simulierenden Simulationsumgebung (20), mit einer Datenbasis, welche die Daten des realen Geländes und der im Gelände befindlichen realen Objekte beinhaltet,
und dass die Daten
- durch eine Auswertung von bei einem Überflug über und/oder bei einer Durchfahrt in der Realumgebung aufgenommen Bildaufnahmen gewonnen werden,
- ein geospezifisches Abbild des realen Geländes und/oder der realen Objekte umfassen, und
- unter anderem als Rasterdaten in der Datenbasis in einem Primärspeicher (9) hinterlegt sind,
wobei zur Darstellung eines Teils der Simulationsumgebung (20) in Abhängigkeit von einer frei wählbaren Darstellungsposition (16) und Darstellungsrichtung (17) der Darstellung der Simulationsumgebung (20) ein Teil der Datenbasis an einen Darstellungsspeicher (11) übertragen wird, **dadurch gekennzeichnet, dass**
in dem Darstellungsspeicher (11) Speicherbereiche (12) mit einer bestimmten Größe (A, B, C) vordefiniert werden und die an den Darstellungsspeicher (11) zu übertragenden Daten der Datenbasis vor der Übertragung in zumindest einer Eigenschaft an die Größe (A, B, C) der vordefinierten Speicherbereiche (12) angepasst werden,
wobei in den Speicherbereichen (12) Umgebungsspeicherbereiche (13) definiert werden, die jeweils zur Abbildung einer Kachel (15) der Simulationsumgebung (20) mit einer festen Grundflächen dienen, wobei die Gesamtheit der Umgebungsspeicherbereiche (13) eine zusammenhängende Teilfläche der Simulationsumgebung (20) in der Umgebung der frei wählbaren Darstellungsposition (16) abbildet,
wobei eine einmalige oder dynamische Zuordnung der Umgebungsspeicherbereiche (13) zu den jeweiligen Kacheln (15) der Simulationsumgebung (20) bezogen auf die frei wählbare Darstellungsrichtung (17) erfolgt, und
wobei Kacheln (15) der Simulationsumgebung (20) in der Nähe der Darstellungsrichtung (17) größere Umgebungsspeicherbereiche (13) zugeordnet werden als Kacheln (15) der Simulationsumgebung (20), die weiter von der Darstellungsrichtung (17) entfernt sind.

2. Verfahren nach Anspruch 1,
**dadurch gekennzeichnet, dass** die dynamische Zuordnung der Umgebungsspeicherbereiche (13) zu einer Kachel (15) der Simulationsumgebung (20) bezogen auf die frei wählbare Darstellungsposition (16) in Abhängigkeit von der Veränderung der Darstellungsposition (16) und/oder der Veränderung der Darstellungsrichtung (17) erfolgt.

3. Verfahren nach einem der Ansprüche 1 bis 2,
**dadurch gekennzeichnet, dass** Kacheln (15) der Simulationsumgebung (20) in der Nähe der frei wählbaren Darstellungsposition (16) größere Umgebungsspeicherbereiche (13) zugeordnet werden als Kacheln (15) der Simulationsumgebung (20) die weiter von der frei wählbaren Darstellungsposition (16) entfernt sind.

4. Verfahren nach einem der Ansprüche 1 bis 3,
**dadurch gekennzeichnet, dass** die Speicherbereiche (12) so ausgestaltet werden, dass die Gesamtgröße der Speicherbereiche (12) der Gesamtgröße des Darstellungsspeichers (11) entspricht.

5. Verfahren nach einem der Ansprüche 1 bis 4,
**dadurch gekennzeichnet, dass** bei einer Veränderung des frei wählbaren Darstellungsposition (16) und/oder der Darstellungsrichtung (17) der Darstellung der Simulationsumgebung (20) über einen Grenzwert eine Anpassung von an den Darstellungsspeicher (11) zu übertragenden Daten der Datenbasis in zumindest einer Eigenschaft an die Größe (A, B, C) der vordefinierten Speicherbereiche (12) und eine Übertragung der angepassten Daten an den Darstellungsspeicher (11) erfolgt, wobei insbesondere der den Inhalt alle Umgebungsspeicherbereiche (13) oder eines vollständigen Satzes von Umgebungsspeicherbereichen (13) ersetzt oder überschrieben werden/wird.

6. Verfahren nach einem der Ansprüche 1 bis 5,
**dadurch gekennzeichnet, dass** die an den Darstellungsspeicher (11) zu übertragenden Daten der Datenbasis hinsichtlich einer maximalen räumlichen Auflösung an die Größe (A, B, C) der Speicherbereiche (12) angepasst werden.

7. Verfahren nach einem der Ansprüche 1 bis 6,
**dadurch gekennzeichnet, dass** die an den Darstellungsspeicher (11) zu übertragenden Daten der Datenbasis hinsichtlich zur Darstellung der Rasterdaten verwendeten Texturen, insbesondere hinsichtlich einer Farbtextur, an die Größe (A, B, C) der Speicherbereiche (12) angepasst werden.

8. Verfahren nach einem der Ansprüche 1 bis 7,
**dadurch gekennzeichnet, dass** die an den Darstellungsspeicher (11) zu übertragenden Daten der Datenbasis hinsichtlich einer Minimal-Glättungstextur an die Größe (A, B, C) der Speicherbereiche (12) angepasst werden.

9. Verfahren nach einem der Ansprüche 1 bis 8,
**dadurch gekennzeichnet, dass** die an den Darstellungsspeicher (11) zu übertragenden Daten der Datenbasis hinsichtlich einer Maximal-Glättungstextur an die Größe (A, B, C) der Speicherbereiche (12) angepasst werden.

10. Verfahren nach einem der Ansprüche 1 bis 9,
**dadurch gekennzeichnet, dass** die an den Darstellungsspeicher (11) zu übertragenden Daten der Datenbasis von jeweils unterschiedlichen Recheneinheiten (8) hinsichtlich mehrerer entsprechend unterschiedlicher Eigenschaften gleichzeitig an die Größe (A, B, C) der Speicherbereiche (12) angepasst werden.

11. Verfahren nach einem der Ansprüche 1 bis 10,
**dadurch gekennzeichnet**, die an den Darstellungsspeicher (11) zu übertragenden Daten der Datenbasis hinsichtlich der Größe von Datenpaketen an die Größe (A, B, C) der Speicherbereiche (12) angepasst werden.

12. Verfahren nach einem der Ansprüche 1 bis 11,
**dadurch gekennzeichnet, dass** ein Abschluss der Anpassung der zu übertragenden Daten an die Größe (A, B, C) des jeweiligen Speicherbereichs (12) in einer Abrufliste (18) des Primärspeichers (9) gespeichert wird.

## Claims

1. Method for representing a computer-generated simulation environment (20) simulating a real environment, having a database containing the data of the real terrain and the real objects situated in the terrain, and wherein the data
- are acquired by way of an evaluation of image recordings recorded during an overflight over and/or a drive through the real environment,
- comprise a geospecific image representation of the real terrain and/or of the real objects, and
- are stored, inter alia, as raster data in the database in a primary memory (9),
wherein a part of the database is transmitted to a representation memory (11) for representing part of the simulation environment (20) on the basis of a freely selectable representation position (16) and representation direction (17) of the representation of the simulation environment (20), **characterized in that** memory regions (12) of a specific size (A, B, C) are predefined in the representation memory (11) and the data of the database that are to be transmitted to the representation memory (11) are adapted in at least one property to the size (A, B, C) of the predefined memory regions (12) before the transmission,
wherein environment memory regions (13) are defined in the memory regions (12), which environment memory regions (13) serve in each case for imaging a tile (15) of the simulation environment (20) with a fixed base area, wherein the entirety of the environment memory regions (13) forms a contiguous partial area of the simulation environment (20) in the environment of the freely selectable representation position (16),
wherein the environment memory regions (13) are assigned once or dynamically to the respective tiles (15) of the simulation environment (20) with reference to the freely selectable representation direction (17), and wherein tiles (15) of the simulation environment (20) in the vicinity of the representation direction (17) are assigned larger environment memory regions (13) than tiles (15) of the simulation environment (20) that are located further away from the representation direction (17).

2. Method according to Claim 1, **characterized in that** the environment memory regions (13) are dynamically assigned to a tile (15) of the simulation environment (20) with reference to the freely selectable representation position (16) on the basis of the change in the representation position (16) and/or the change in the representation direction (17).

3. Method according to one of Claims 1 to 2, **characterized in that** tiles (15) of the simulation environment (20) in the vicinity of the freely selectable representation position (16) are assigned larger environment memory regions (13) than tiles (15) of the simulation environment (20) that are located further away from the freely selectable representation position (16).

4. Method according to one of Claims 1 to 3, **characterized in that** the memory regions (12) are configured such that the overall size of the memory regions (12) corresponds to the overall size of the representation memory (11).

5. Method according to one of Claims 1 to 4, **characterized in that**, in the case of a change in the freely selectable representation position (16) and/or the representation direction (17) of the representation of the simulation environment (20) above a limit value, data of the database that are to be transmitted to the representation memory (11) are adapted in at least one property to the size (A, B, C) of the predefined memory regions (12) and the adapted data are transmitted to the representation memory (11), wherein in particular the content of all the environment memory regions (13) or of a complete set of environment memory regions (13) are/is replaced or overwritten.

6. Method according to one of Claims 1 to 5, **characterized in that** the data of the database that are to be transmitted to the representation memory (11) are adapted to the size (A, B, C) of the memory regions (12) with respect to a maximum spatial resolution.

7. Method according to one of Claims 1 to 6, **characterized in that** the data of the database that are to be transmitted to the representation memory (11) are adapted to the size (A, B, C) of the memory regions (12) with respect to textures used for the representation of the raster data, in particular with respect to a colour texture.

8. Method according to one of Claims 1 to 7, **characterized in that** the data of the database that are to be transmitted to the representation memory (11) are adapted to the size (A, B, C) of the memory regions (12) with respect to a minimum smoothing texture.

9. Method according to one of Claims 1 to 8, **characterized in that** the data of the database that are to be transmitted to the representation memory (11) are adapted to the size (A, B, C) of the memory regions (12) with respect to a maximum smoothing texture.

10. Method according to one of Claims 1 to 9, **characterized in that** the data of the database that are to be transmitted to the representation memory (11) are adapted by respectively different computing units (8) to the size (A, B, C) of the memory regions (12) with respect to a plurality of correspondingly different properties at the same time.

11. Method according to one of Claims 1 to 10, **characterized in that** the data of the database that are to be transmitted to the representation memory (11) are adapted to the size (A, B, C) of the memory regions (12) with respect to the size of data packets.

12. Method according to one of Claims 1 to 11, **characterized in that** a completion of the adaptation of the data to be transmitted to the size (A, B, C) of the respective memory region (12) is stored in a call-up list (18) of the primary memory (9).

## Revendications

1. Procédé permettant de représenter un environnement de simulation (20) généré par ordinateur et simulant un environnement réel, comprenant une base de données qui contient les données du terrain réel et des objets réels qui se trouvent sur le terrain, et dans lequel les données
- sont obtenues par une évaluation de prises de vue enregistrées lors d'un survol et/ou d'une traversée de l'environnement réel,
- comprennent une reproduction géospécifique du terrain réel et/ou des objets réels, et
- sont stockées entre autres sous forme de données de trame dans la base de données dans une mémoire primaire (9),
dans lequel, pour la représentation d'une partie de l'environnement de simulation (20) en fonction d'une position de représentation (16) et d'une direction de représentation (17), pouvant être choisies librement, de la représentation de l'environnement de simulation (20), une partie de la base de données est transmise à une mémoire de représentation (11), **caractérisé en ce que** dans la mémoire de représentation (11), des zones de mémoire (12) d'une dimension déterminée (A, B, C) sont prédéfinies, et les données de la base de données à transmettre à la mémoire de représentation (11) sont adaptées quant à au moins une propriété à la dimension (A, B, C) des zones de mémoire (12) prédéfinies avant la transmission, dans lequel, dans les zones de mémoire (12), des zones de mémoire d'environnement (13) sont définies qui servent respectivement à reproduire une mosaïque d'image (15) de l'environnement de simulation (20) ayant une surface de base fixe, la totalité des zones de mémoire d'environnement (13) reproduisant une surface partielle cohérente de l'environnement de simulation (20) dans l'environnement de la position de représentation (16) pouvant être choisie librement,
dans lequel une attribution unique ou dynamique des zones de mémoire d'environnement (13) aux mosaïques d'image respectives (15) de l'environnement de simulation (20) est effectuée par rapport à la direction de représentation (17) pouvant être choisie librement, et
à des mosaïques d'image (15) de l'environnement de simulation (20) à proximité de la direction de représentation (17) étant attribuées des zones de mémoire d'environnement (13) plus grandes qu'à des mosaïques d'image (15) de l'environnement de simulation (20) qui sont plus éloignées de la direction de représentation (17).

2. Procédé selon la revendication 1, **caractérisé en ce que** l'attribution dynamique des zones de mémoire d'environnement (13) à une mosaïque d'image (15) de l'environnement de simulation (20) est effectuée par rapport à la position de représentation (16) pouvant être choisie librement en fonction de la variation de la position de représentation (16) et/ou de la variation de la direction de représentation (17).

3. Procédé selon l'une quelconque des revendications 1 à 2, **caractérisé en ce qu'**à des mosaïques d'image (15) de l'environnement de simulation (20) à proximité de la position de représentation (16) pouvant être choisie librement sont attribuées des zones de mémoire d'environnement (13) plus grandes qu'à des mosaïques d'image (15) de l'environnement de simulation (20) qui sont plus éloignées de la position de représentation (16) pouvant être choisie librement.

4. Procédé selon l'une quelconque des revendications 1 à 3, **caractérisé en ce que** les zones de mémoire (12) sont configurées de telle sorte que la dimension totale des zones de mémoire (12) correspond à la dimension totale de la mémoire de représentation (11).

5. Procédé selon l'une quelconque des revendications 1 à 4, **caractérisé en ce que** lors d'une variation de la position de représentation (16) et/ou de la direction de représentation (17), pouvant être choisies librement, de la représentation de l'environnement de simulation (20) au-dessus d'une valeur seuil, une adaptation des données de la base de données à transmettre à la mémoire de représentation (11) à la dimension (A, B, C) des zones de mémoire (12) prédéfinies est effectuée quant à au moins une propriété, et une transmission des données adaptées à la mémoire de représentation (11) est effectuée, dans lequel en particulier le contenu de toutes les zones de mémoire d'environnement (13) ou d'un ensemble complet de zones de mémoire d'environnement (13) est remplacé et/ou écrasé.

6. Procédé selon l'une quelconque des revendications 1 à 5, **caractérisé en ce que** les données de la base de données à transmettre à la mémoire de représentation (11) sont adaptées à la dimension (A, B, C) des zones de mémoire (12) concernant une résolution spatiale maximale.

7. Procédé selon l'une quelconque des revendications 1 à 6, **caractérisé en ce que** les données de la base de données à transmettre à la mémoire de représentation (11) sont adaptées à la dimension (A, B, C) des zones de mémoire (12) concernant des textures utilisées pour représenter les données de trame, en particulier concernant une texture chromatique.

8. Procédé selon l'une quelconque des revendications 1 à 7, **caractérisé en ce que** les données de la base de données à transmettre à la mémoire de représentation (11) sont adaptées à la dimension (A, B, C) des zones de mémoire (12) concernant une texture de lissage minimal.

9. Procédé selon l'une quelconque des revendications 1 à 8, **caractérisé en ce que** les données de la base de données à transmettre à la mémoire de représentation (11) sont adaptées à la dimension (A, B, C) des zones de mémoire (12) concernant une texture de lissage maximal.

10. Procédé selon l'une quelconque des revendications 1 à 9, **caractérisé en ce que** les données de la base de données à transmettre à la mémoire de représentation (11) de différentes unités de calcul (8) respectivement sont adaptées en même temps à la dimension (A, B, C) des zones de mémoire (12) concernant plusieurs propriétés différentes en conséquence.

11. Procédé selon l'une quelconque des revendications 1 à 10, **caractérisé en ce que** les données de la base de données à transmettre à la mémoire de représentation (11) sont adaptées à la dimension (A, B, C) des zones de mémoire (12) concernant la dimension de paquets de données.

12. Procédé selon l'une quelconque des revendications 1 à 11, **caractérisé en ce qu'**une fin de l'adaptation des données à transmettre à la dimension (A, B, C) de la zone de mémoire respective (12) est stockée dans une liste de consultation (18) de la mémoire primaire (9).
